# EUROPÄISCHE PATENTSCHRIFT

(11) **EP 2 884 824 B1**
(45) Veröffentlichungstag und Bekanntmachung des Hinweises auf die Patenterteilung: **23.08.2017**
(21) Anmeldenummer: 14194851.3
(22) Anmeldetag: 26.11.2014
(51) Int. Cl.: H05H 1/46, H01J 37/32

(54) **Vorrichtung und Verfahren zur Oberflächenbehandlung von Kleinteilen mittels Plasma**
Device and method for the surface treatment of small parts by means of plasma
Dispositif et procédé de traitement surfacique de petites pièces par plasma

(30) Priorität: 11.12.2013 DE 102013225608
(43) Veröffentlichungstag der Anmeldung: 17.06.2015
(73) Patentinhaber: APO GmbH Massenkleinteilbeschichtung, 52477 Alsdorf (DE)
(72) Erfinder: Pozo, Antonio, 52477 Alsdorf (DE); Gangloff, Jens, 52159 Roetgen (DE); Zeller, Markus, 52372 Kreuzau (DE)
(74) Vertreter: Bauer, Dirk

(56) Entgegenhaltungen:
- EP-A2- 0 326 191
- WO-A2-97/25078
- DE-A1-102004 015 231
- US-A- 5 336 326
- US-A1- 2004 018 320

## Beschreibung

### Einleitung

Die vorliegende Erfindung betrifft eine Vorrichtung zum Behandeln von Kleinteilen mittels eines Plasmas gemäß Anspruch 1. Darüber hinaus betrifft die Erfindung ein Verfahren zum Behandeln von Kleinteilen gemäß Anspruch 10. Als Kleinteile werden im Sinne dieser vorliegenden Anmeldung sämtliche Festkörper verstanden, welche an ihrer Oberfläche mittels des Plasmas gereinigt und/oder aktiviert werden können, um anschließend z. B. eine bessere Haftung eines Lackes zu ermöglichen. Typischerweise gehören dazu aus Kunststoff oder Metall gefertigte schüttfähige Kleinteile (Schüttgut),wie beispielsweise Gummi-O-Ringe, Klemmbausteine, Ventile für verschiedene Einsatzbereiche, etc.

Ein Plasma ist ein Gas, dessen Bestandteile teilweise oder vollständig aus Ionen, freien Elektronen, angeregten Atomen, Radikalen (freien Atomen), Molekülfragmenten und Photonen bestehen, wobei die wichtigsten Bestandteile zur Oberflächenbehandlung von den Ionen, freien Elektronen und Radikalen gebildet werden. Unter einem Plasma wird im Sinne der vorliegenden Anmeldung insbesondere ein Niederdruck-Plasma verstanden, welches in einem evakuierten Raum erzeugt wird. Ein Niederdruck-Plasma zeichnet sich dadurch aus, dass es sich nicht in einem thermodynamischen Gleichgewicht befindet. Das heißt, dass die Elektronen "heiß" und die Ionen "kalt" (gemessen in eV) sind. Die Elektronen sind allerdings nur in einer unbedeutenden Anzahl vorhanden, somit sind die Ionen für die Wärmeübertragung zuständig. Die "kalten" Ionen halten den Wärmegehalt des gesamten Systems relativ niedrig. Alternativ handelt es sich im Sinne dieser Anmeldung um ein Mikrowellen-Plasma, welches mittels einer Frequenz im GHz-Bereich erzeugt wird.

Zur Erzeugung des Plasmas werden typischerweise zwei Elektroden verwendet. Mittels einer hochfrequenten Wechselspannung wird an den beiden Elektroden ein Wechselfeld erzeugt, welches zur Ionisation eines Prozessgases und somit zur Erzeugung von Plasma führt. Während der Ionisation treffen freie Elektronen auf Moleküle oder Atome, wodurch wiederum lawinenartig weitere Elektronen freigesetzt werden.

### Stand der Technik

Vorrichtungen und Verfahren der vorgenannten Art sind allgemein bekannt und werden zur Oberflächenbehandlung von verschiedensten Teilen eingesetzt.

Typischerweise bildet die Dreheinrichtung eine erste Elektrode, wobei an diese als erster Pol eine Spannung angelegt wird, und das Gehäuse bildet eine zweite Elektrode und ist somit ein Gegenpol zu der ersten Elektrode. Nach der Unterbringung der Kleinteile in einem koaxial zu der Dreheinrichtung angeordneten Träger und dem Verschließen des Gehäuses wird in dem Innenraum ein Unterdruck erzeugt. Anschließend wird ein Prozessgas in den Innenraum des Gehäuses eingeführt, bevor Spannung angelegt und somit das Wechselfeld erzeugt wird. Die Ionen in dem vom Wechselfeld erzeugten Plasma kollidieren mit der Oberfläche der Kleinteile und gehen eine chemische Verbindung mit den Verschmutzungen, welche sich auf den Kleinteilen befinden, ein. Zusätzlich findet eine Reinigung der Oberfläche statt, indem die Verschmutzungen durch den Aufprall von Ionen und Elektronen 'abgesprengt' werden. Bei der Aktivierung der Oberfläche der Kleinteile werden die unpolaren Oberflächen durch Beschuss aufgebrochen und Radikale können sich anlegen. Dies führt zu einer besseren Haftung eines später auf die Oberfläche der Kleinteile aufzubringenden Lackes. Eine ähnliche Vorrichtung wird in der DE 196 09 804 C1 beschrieben, wobei die Plasmaeinrichtung innerhalb der Dreheinrichtung angeordnet ist. Nachteilig an dieser Art der Vorrichtungen ist, dass die Dreheinrichtung, welche sich während der Behandlung in Bewegung, das heißt, Rotation, befindet, die Elektrode bildet. Der Aufbau dieser Vorrichtungen ist dementsprechend aufwendig und kostenintensiv. Hinzu kommt, dass die direkte Anlegung einer Spannung an die Dreheinrichtung zu einem hohen Wärmeeintrag und somit zu einer starken Erhitzung der Bauteile führt. Durch die starke Erhitzung kann es bei schmalen Spalten zwischen den einzelnen Bauteilen zu einem Funkenschlag führen. Der Verschleiß der Teile ist somit hoch und der Austausch einer Dreheinrichtung zeitaufwendig und kostenintensiv. Auch die in der DE 10 2004 015 231 A1 zu behandelnden Teile werden mit einer elektrischen Spannung beaufschlagt, was somit zu einem Verschleiß der Dreheinrichtung und der Teile führt.

Die DE 196 28 102 A1 beschreibt eine Vakuumbeschichtungsanlage, wobei jeweils zwei Elektroden in einem anderen Raum angeordnet sind, welche abwechselnd je nach Prozessablauf mit einem Behandlungsraum verbunden werden können. Ein zu beschichtendes Teil wird auf einer mit einer Bias-Spannung beaufschlagten Halterung angebracht und um seine eigene vertikale Achse gedreht.

Die US 4,713,585 beschreibt eine Vorrichtung zur Erzeugung eines lonenstrahls, der es ermöglicht, auch größere Gegenstände zu ionisieren. Dazu wird zunächst Plasma in einer Plasmakammer mittels einer Hochfrequenz-Spule erzeugt. In dieser Plasmakammer befinden sich ferner Magnete, die das Plasma gleichmäßig in der Kammer verteilen. Um eine größere Plasmawolke mit einer möglichst ähnlichen Energiedichte zu erhalten, befindet sich im Anschluss an die Plasmakammer eine Plasmaexpansionskammer, welche zusätzliche kreisförmig angeordnete Magneten aufweist. Über eine Strahlextraktionselektrode werden schließlich Ionenstrahlen in eine Vakuumkammer eingeleitet, in der sich die zu behandelnden Werkstücke befinden.

Aus der DE 40 29 268 C2, DE 44 12 902 A1, US5336326 US 7,601,405 B2 gehen weitere Vorrichtungen und Verfahren zur Behandlung von einem oder mehreren Gütern hervor. Zwischen zwei stillstehenden Elektroden wird eine Plasmawolke erzeugt, welche das entsprechende Gut behandeln soll. Das Gut wird zwischen den beiden Elektroden angeordnet.

In der US 2004/0018320 wird eine weitere Vorrichtung beschrieben, in der ein Plasma in einer Plasmakammer erzeugt und durch eine Öffnung in einen Behandlungsraum geleitet wird. Die Plasmakammer wird an einer dem Behandlungsraum zugewandten Seite von einer Anode begrenzt. Innerhalb der Plasmakammer ist eine Kathode angeordnet. Damit das Plasma jedoch in den Behandlungsraum gelangen kann, fungieren entweder die Wände des Behandlungsraums, eine Anlagefläche für die zu behandelnden Gegenstände oder die Gegenstände selbst als eine weitere Anode, wodurch sich die vorgenannten Nachteile

WO 9725078 offenbart eine Vorrichtung zum Behandeln von Kleinteilen mittels eines Plasmas.

DE 10 2004 015 231 offenbart eine Vorrichtung mit den im Oberbegriff des Anspruchs 1 angegebenen Merkmalen.

### Aufgabe

Der vorliegenden Erfindung liegt nunmehr die Aufgabe zugrunde, eine Vorrichtung und ein Verfahren der eingangs beschriebenen Art derart weiterzuentwickeln, dass eine Aufheizung der mechanischen Bestandteile und somit ein Verschleiß gering gehalten wird.

### Lösung

Diese Aufgabe wird erfindungsgemäß dadurch gelöst, dass die Plasmaeinrichtung sich in einem Nebenraum befindet, der außerhalb eines Einwirkungsbereichs angeordnet ist, der von der Dreheinrichtung und dem Träger und den zu behandelnden Kleinteilen überstrichen wird und einen Teil des Innenraums bildet.

Anders als aus dem Stand der Technik bekannt, bilden nicht das Gehäuse und die Dreheinrichtung die Elektroden zur Erzeugung des Plasmas, sondern die Elektroden sind stillstehend und getrennt von der Dreheinrichtung angeordnet. Dadurch wird eine aufwendige und kostspielige Dreheinrichtung mit einer sich bewegenden Spannungsdurchführung durch das Gehäuse vermieden. Die Hitzeeinwirkung während des Behandlungsvorgangs wird reduziert und somit der Verschleiß der Vorrichtung sowie die thermische Beanspruchung der behandelten Kleinteile gesenkt und die Lebensdauer der Dreheinrichtung, des Gehäuses und der anderen Bauteile gesteigert.

Die Elektroden sollten nicht unmittelbar in dem Einwirkungsbereich des Gehäuses, sondern in der davon getrennten Plasmaeinrichtung, welche sich vorzugsweise in einem Nebenraum des Gehäuses befindet, angeordnet sein. Das heißt, dass die Kleinteile während der Behandlung nicht zwischen den Elektroden angeordnet sind. Das Gehäuse weist in diesem Fall neben dem Nebenraum auch einen Behandlungsraum auf, in dem die Bewegung der Kleinteile und somit die eigentliche Behandlung stattfindet.

Der Behandlungsraum in dem Gehäuse weist vorzugsweise eine zylindrische Form auf, wobei die Achse des Zylinders horizontal angeordnet ist und somit eine erste Stirnfläche und eine zweite Stirnfläche des Zylinders vertikal angeordnet sind. An einer Mantelfläche des Zylinders sollte sich der vorzugsweise quaderförmige Nebenraum befinden. Der Nebenraum ist außerhalb des Einwirkungsbereichs, der von der Dreheinrichtung und dem Träger und den zu behandelnden Kleinteilen überstrichen wird, angeordnet. Die Plasmaeinrichtung befindet sich in dem Nebenraum, vorzugsweise an den Seitenwänden des Nebensraums. Das Plasma ist dementsprechend nicht, wie im Stand der Technik, unmittelbar in der Behandlungskammer, sondern in dem Nebenraum erzeugbar, sich gleichwohl aber in den Einwirkungsbereich des Innenraumes des Gehäuses hinein erstreckt. Die Erzeugung des Plasmas wird somit von dem Gehäuse und der Dreheinrichtung entkoppelt, wodurch der Wärmeeintrag auf diese und die Kleinteile reduziert wird. Weiterhin ermöglicht diese Anordnung eine definierte Ausbreitung des Plasmas.

Wie bereits erwähnt, befindet sich die Plasmaeinrichtung in dem Nebenraum, wobei letzterer an der Mantelfläche des zylinderförmigen Behandlungsraumes angeordnet ist. Aufgrund dieser Anordnung hat es sich als vorteilhaft erwiesen, dass sich die Plasmaeinrichtung auch auf der Mantelfläche des Behandlungsraumes befindet. Daraus ergibt sich zudem der Vorteil, dass die Plasmaeinrichtung außerhalb des Einwirkungsbereichs angeordnet ist und somit eine große Hitzeeinwirkung beispielsweise auf die Dreheinrichtung und den Träger vermieden wird. Der Nebenraum mit der Plasmaeinrichtung kann an jeder beliebigen Position auf der Mantelfläche angebracht werden, wobei eine Anbringung oberhalb der horizontalen Drehachse den Vorteil aufweist, dass aufgrund der Schwerkraft keine Schmutzpartikel oder zu behandelnde Kleinteile in den Nebenraum gelangen, sich dort ablagern und gegebenenfalls festbrennen können.

Eine Plasmawolke erstreckt sich von dem Nebenraum in den eigentlichen Behandlungsraum. Erfindungsgemäß kann dabei vorgesehen sein, dass die Kleinteile während der Behandlung in dem Innenraum beziehungsweise in dem als Behandlungsraum zu bezeichnenden Teil des Gehäuses in oder an mindestens einem Träger insbesondere in Form eines Korbes angeordnet sind, der vorzugsweise mittels der Dreheinrichtung drehbar ist, wobei das Gehäuse zylinderförmig ist und die Dreheinrichtung eine koaxial zu der Achse des Gehäuses verlaufende Drehachse besitzt. Die gesamte Oberfläche der Kleinteile kann durch diese Art der Unterbringung und die daraus resultierende fortlaufende Umwälzung behandelt werden, ohne dass der Behandlungsprozess zwischenzeitlich unterbrochen werden muss, um die Kleinteile zu wenden. Die Dreheinrichtung mit den daran fixierten Trägern ermöglicht ein Umwälzen der Kleinteile, so dass alle Oberflächenbereiche sämtlicher Kleinteile dem Plasma ausgesetzt werden.

Eine Arbeitsfrequenz der Plasmaeinrichtung beträgt bei der Vorrichtung nach der Erfindung zwischen 2 MHz und 20 MHz, vorzugsweise zwischen 5 MHz und 15 MHz, weiter vorzugsweise bei 13,56 MHz, um eine hohe Energiedichte und folglich eine gute Oberflächenbehandlung der Kleinteile zu ermöglichen. Optional kann allerdings auch eine Plasmaeinrichtung, welche ein Mikrowellen-Plasma erzeugt, mit einer Frequenz im GHz - Bereich verwendet werden.

Die in der Plasmaeinrichtung angeordneten Elektroden sind in einer vorteilhaften Ausgestaltung der Erfindung plattenförmig oder stabförmig. Infolgedessen kann ein homogenes dreidimensionales Wechselfeld und somit eine große Plasmawolke erzeugt werden. Alternativ ist vorgesehen, dass mindestens zwei Elektroden in mindestens einer Röhre angeordnet sind, wobei innerhalb der mindestens einen Röhre ein Vakuum erzeugt werden kann. Die Röhre wird in dem Nebenraum angebracht und erzeugt dort ein Plasma, welches sich in den Behandlungsraum ausbreitet.

Die Erfindung weiter ausgestaltend ist vorgesehen, dass die Elektroden parallel zu einer Ebene senkrecht zu der Drehachse der Dreheinrichtung oder parallel zu der Drehachse der Dreheinrichtung angeordnet sind. Sind die Elektroden parallel zu der Drehachse der Dreheinrichtung angeordnet, sollten sie eine Länge aufweisen, welche der Gehäusebreite, das heißt, insbesondere dem Abstand zwischen der ersten und der zweiten Stirnfläche des das Gehäuse bildenden Zylinders und somit der Höhe der Mantelfläche entspricht. Folglich kann der Abstand zwischen den beiden Elektroden verändert beziehungsweise an die Maße des Nebenraums angepasst werden beziehungsweise bestimmt diese. Alternativ sind die Elektroden parallel zu einer Ebene senkrecht zu der Drehachse angeordnet. In diesem Fall wird das Wechselfeld in eine Richtung, welche parallel zu der Drehachse angeordnet ist, erzeugt. Die Länge der Elektroden ist in diesem Fall relativ frei wählbar beziehungsweise kann somit an die notwendige Länge, welche für das Wechselfeld benötigt wird, angepasst werden. Der Abstand der Elektroden zueinander sollte der Gehäusebreite entsprechen.

Optional ist vorgesehen, dass die plattenförmigen Elektroden gemeinsam eine Zarge mit vorzugsweise zwei Trennstellen bilden. Das heißt, dass sich zwei plattenförmige Elektroden gegenüberliegen, welche an zwei sich der Länge nach gegenüberliegenden Enden abgeknickt sind und somit die Form eines lang gestreckten U aufweisen, und vorzugsweise sowohl parallel zu einer Ebene senkrecht zu der Drehachse der Dreheinrichtung als auch parallel zu der Drehachse der Dreheinrichtung angeordnet sind, wobei zwischen den Elektroden vorzugsweise ein Spalt vorgesehen ist. Dies hat den Vorteil, dass eine Ausbreitung des Plasmas in Richtung des Behandlungsraumes verstärkt wird, da eine Ausbreitung zu den Seitenwänden des Nebenraumes durch diese Anordnung verhindert wird. Das Plasma kann sich somit in eine definierte Richtung ausbreiten. Die Ausbreitung und Verteilung des Plasmas erfolgt nicht mit Ablenkungsmagneten.

Weiter verstärkt wird die Ausbreitung des Plasmas in Richtung des Behandlungsraumes, indem vorzugsweise das Prozessgas kontinuierlich in den Nebenraum eingeleitet und an einer dem Nebenraum abgewandten Seite des Gehäuses aus dessen Innenraum heraus gesaugt wird. Das Prozessgas besteht vorzugsweise aus Sauerstoff, Stickstoff, Wasserstoff, Edelgasen und /oder Kohlenstoff, wobei die Verwendung anderer Prozessgase nicht ausgeschlossen ist. Das Plasma 'strömt' dementsprechend in den Behandlungsraum hinein, in dem sich die zu behandelnden Kleinteile befinden.

Die Erzeugung von Plasma muss in einem evakuierten Raum stattfinden, dazu ist es besonders vorteilhaft, wenn die Plasmaeinrichtung eine separate Vakuumkammer aufweist, die von dem Innenraum des Gehäuses getrennt ist und vorzugsweise mittels einer weiteren Vakuumpumpe evakuierbar ist. Die Vakuumkammer, in der die Elektroden angeordnet sind, ist vorzugsweise mittels einer Verglasung von dem Nebenraum abgetrennt. Die weitere Vakuumpumpe ist zur Evakuierung der Plasmaeinrichtung vorgesehen und soll das angestrebte Vakuum während der Behandlung fortlaufend aufrechterhalten. Mittels der zusätzlichen Vakuumpumpe kann ein geringeres Vakuum in der Plasmaeinrichtung erlangt werden. Hinzu kommt, dass das Prozessgas in dem Behandlungsraum nicht mit der Vakuumkammer der Plasmaeinrichtung in Kontakt kommt.

Um eine optimale Oberflächenbehandlung der Kleinteile zu erzielen ist es besonders vorteilhaft, wenn die Plasmaeinrichtung so angeordnet ist, dass ein Abstand zwischen den in einem Träger in Form eines Korbes angeordneten schüttfähigen Kleinteilen (Schüttgut) und der Plasmaeinrichtung dann minimal ist, wenn die Kleinteile sich in Folge der Drehbewegung des Trägers im freien Fall oder der, über ein Zyklus der Rotation betrachtet, stärksten Wälzbewegung befinden. Die Kleinteile sind lose in dem Träger angeordnet und werden durch die Drehbewegung der Dreheinrichtung fortlaufend umgewälzt. Aufgrund der Tatsache, dass die Energie der Ionen, Elektronen und Radikale in der Nähe der Plasmaeinrichtung am höchsten ist, führt es zu besonders guten Ergebnissen, wenn sich die Kleinteile genau dort im freien Fall befinden, da zu diesem Zeitpunkt die Ionen, Elektronen und Radikalen die Kleinteile an ihrer gesamten Oberfläche erreichen können.

In konstruktiver Hinsicht ist erfindungsgemäß vorgesehen, dass die Träger relativ zu der Dreheinrichtung stillstehen, wodurch eine optimale Behandlung der Kleinteile erreicht werden kann. Eine Wälz- beziehungsweise Fallbewegung der Kleinteile wird gleichwohl aufgrund der Rotation der Dreheinrichtung selbst erreicht.

Ferner betrifft die Offenbarung ein Verfahren zum Behandeln von Kleinteilen in einem Plasma mit den folgenden Verfahrensschritten:
a) In ein Gehäuse, dessen Innenraum druckdicht abschließbar und durch eine verschließbare Öffnung zugänglich ist, werden die zu behandelnden Kleinteile eingebracht.
b) Der Innenraum des Gehäuses wird druckdicht abgeschlossen.
c) Der Innenraum des Gehäuses wird mittels einer Vakuumpumpe evakuiert.
d) In dem Innenraum des Gehäuses wird mittels einer Plasmaeinrichtung ein Plasma erzeugt, das den Innenraum zumindest teilweise erfüllt.
e) Die in dem Innenraum des Gehäuses befindlichen Kleinteile werden mittels einer zumindest teilweise in dem Innenraum befindlichen Dreheinrichtung gedreht, und
f) Das Plasma zwischen zwei stillstehenden Elektroden erzeugt wird.

Erfindungsgemäß ist vorgesehen, dass das Plasma in einem Nebenraum erzeugt wird, der außerhalb eines Beinwirkungsbereichs angeordnet ist, der von der Dreheinrichtung und dem Träger und den zu behandelnden Kleinteilen überstrichen wird und einen Teil des Innenraums bildet.. Nach der Evakuierung der Plasmaeinrichtung und des Innenraumes wird ein Prozessgas, beispielsweise Argon, Sauerstoff, Stickstoff, etc. in den Innenraum eingeleitet. Danach wird eine Wechselspannung an die beiden Elektroden angelegt und somit ein Wechselfeld zwischen den Elektroden erzeugt. Daraus ergeben sich die zu der Vorrichtung genannten Vorteile.

Die Oberflächenbehandlung der Kleinteile sollte möglichst gleichmäßig und vollständig erfolgen, dementsprechend ist es besonders vorteilhaft, wenn die Kleinteile in Folge der durch die Dreheinrichtung bewerkstelligten Drehung während der Behandlung ihren Abstand zu der Plasmaeinrichtung ändern. Die Drehbewegung ermöglicht, dass die Kleinteile sich zyklisch im freien Fall befinden. Dies ist vorzugsweise dann der Fall, wenn der Abstand der Kleinteile zu der Plasmaeinrichtung am geringsten ist. Da die Menge der Radikale und Ionen in der Nähe der Plasmaeinrichtung am größten ist, findet eine gleichmäßige Reinigung und/oder Aktivierung der Kleinteile von allen Seiten statt.

Dabei ist vorgesehen, dass die Kleinteile in Folge der von der Dreheinrichtung bewerkstelligten Drehung vorzugsweise zyklisch an der Plasmaeinrichtung vorbei geführt werden, wobei vorzugsweise der Abstand zwischen der Plasmaeinrichtung und den Kleinteilen, die der Plasmaeinrichtung am nächsten kommen, kleiner als 200 mm, vorzugsweise kleiner als 100 mm beträgt. Dadurch kann erreicht werden, dass die schüttfähigen Kleinteile ausreichend nah an der Plasmaeinrichtung vorbeigeführt werden und die Kleinteile dementsprechend durch einen Bereich, an dem die Energiedichte und die Menge der Ionen, Elektronen und Radikale am höchsten ist, geführt werden.

Schließlich ist noch vorgesehen, dass die Dreheinrichtung mit einer Drehzahl zwischen 10 min⁻¹ und 30 min⁻¹, vorzugsweise zwischen 12 min⁻¹ und 20 min⁻¹, rotiert. Diese Drehzahl der Dreheinrichtung ermöglicht einen freien Fall der Kleinteile in der Nähe der Plasmaeinrichtung und verursacht somit eine möglichst gleichmäßige Oberflächenbehandlung der Kleinteile.

### Ausführungsbeispiel

Die vorstehend beschriebene Erfindung wird nachfolgend anhand eines Ausführungsbeispiels, das in den Figuren dargestellt wird, näher erläutert.

Es zeigt:
- Fig. 1:: eine Seitenansicht einer erfindungsgemäßen Vorrichtung,
- Fig. 2:: ein Vertikalschnitt durch ein Gehäuse der erfindungsgemäßen Vorrichtung,
- Fig. 3:: ein Querschnitt durch das Gehäuse gemäß Figur 2 und
- Fig. 4:: ein Schaltbild einer Anordnung von Vakuumpumpen.

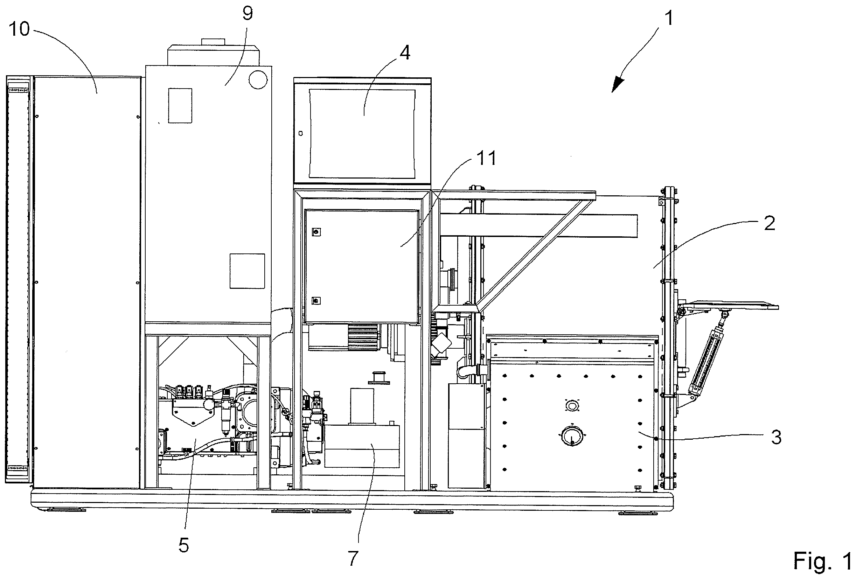

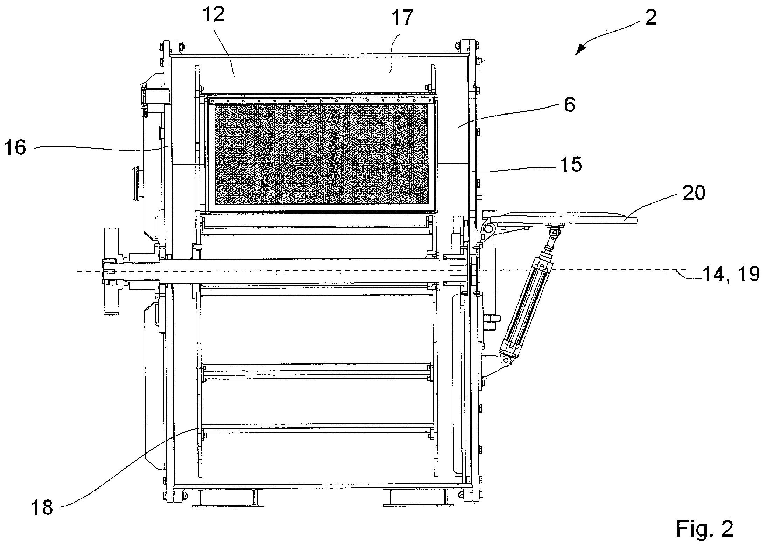

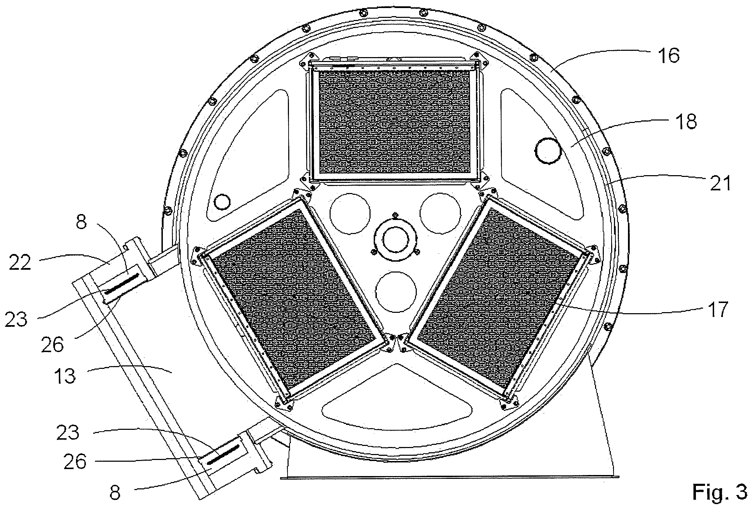

In Figur 1 wird eine Vorrichtung **1** zur Oberflächenbehandlung von Kleinteilen dargestellt. Die Vorrichtung **1** weist ein Gehäuse **2** mit einer Plasmaeinrichtung **3** auf, welche in den Figuren 2 und 3 weiter beschrieben werden. Eine Steuereinheit **4** dient zur Einstellung verschiedener Prozessabläufe der Plasmaeinrichtung **3.** Weiterhin befinden sich an der Vorrichtung **1** eine Vakuumpumpe **5** zur Evakuierung eines Innenraumes **6** gemäß Figur 2 in dem Gehäuse **2** und eine weitere Vakuumpumpe **7** zu Evakuierung einer Vakuumkammer **8** gemäß Figur 3 in der Plasmaeinrichtung **3.** Zusätzlich befindet sich an der Vorrichtung **1** noch eine Kühleinrichtung **9,** wobei diese mittels Wasserkühlung der während des Behandlungsvorganges entstehenden Hitze entgegenwirkt. In einem Schaltschrank **10** befinden sich alle elektronischen Komponenten der Vorrichtung **1,** welche zur Steuerung und Regelung der Vorrichtung **1** notwendig sind. Ein spezieller Pneumatikschrank **11** ermöglicht eine einfache Einstellung der verschiedenen Drücke und eine Einstellbarkeit der Druckluftversorgung.

Die Figur 2 zeigt einen Vertikalschnitt des Gehäuses **2** in einer vergrößerten Darstellung, wobei dieser parallel zur Seitenansicht der Vorrichtung **1** gemäß Figur 1 angeordnet ist. Das Gehäuse **2** begrenzt den Innenraum **6,** wobei der Innenraum **6** sich in einen Behandlungsraum **12** und einen Nebenraum **13** gemäß Figur 3 unterteilen lässt. Der Behandlungsraum **12** des Gehäuses **2** besitzt eine zylindrische Form, wobei eine Achse **14** in einem Kreismittelpunkt des Gehäuses **2** horizontal angeordnet ist. Folglich sind sowohl eine erste Stirnfläche **15,** welche dem Fachpersonal zugewandt ist und eine in den Figuren nicht sichtbare Öffnung aufweist, als auch eine zweite Stirnfläche **16,** welche dem Fachpersonal abgewandt ist, vertikal angeordnet.

Nachdem die Kleinteile in einem Träger **17,** beispielsweise in Form eines Korbes, untergebracht wurden, wird dieser durch die Öffnung in den Behandlungsraum **12,** in eine Dreheinrichtung **18** geschoben, und dort fixiert. Anschließend wird die Dreheinrichtung **18** eine Dritteldrehung um eine Drehachse **19** weiter gedreht, um den nächsten Träger **17** in der Dreheinrichtung **18** anzubringen. Die Drehachse **19** ist horizontal und koaxial zu der Achse **14** des Gehäuses **2** angeordnet. Nach einer weiteren Dritteldrehung wird der letzte Träger **17** in der Dreheinrichtung **18** angebracht. Um den Innenraum **6** druckdicht zu verschließen, wird die Öffnung mittels einer Tür **20** luftdicht verschlossen.

In Figur 3 ist ein Querschnitt des Gehäuses **2** mit den drei in der Dreheinrichtung **17** befestigten Trägern **17** dargestellt. An einer Mantelfläche **21** des Gehäuses **2** befindet sich der rechteckige Nebenraum **13** in dem später Plasma erzeugt wird. An Seitenwänden **22** des Nebenraumes **13** befindet sich die Plasmaeinrichtung **3.** In der Vakuumkammer **8** der Plasmaeinrichtung **3** sind zwei Elektroden **23,** beispielsweise in Form von Platten, angeordnet. Der Nebenraum **13** und die Vakuumkammer **8** sind mittels einer Verglasung **26** luftdicht voneinander getrennt. Die beiden Elektroden **23** befinden sich an zwei sich gegenüberliegenden Seiten der Plasmaeinrichtung **3,** wobei die Elektroden **24** in diesem Ausführungsbeispiel senkrecht zu den Stirnflächen **15, 16** des Gehäuses 2 stehen. Alternativ können diese in einem hier nicht dargestellten Ausführungsbeispiel auch parallel zu einer von den Stirnflächen **15, 16** gebildeten Ebenen angeordnet sein.

In einer weiteren hier nicht dargestellten Ausführungsform sind die plattenförmigen Elektroden ihrer Länge nach an den jeweiligen Enden abgeknickt und weisen eine lang gestreckte U-Form auf. Folglich befinden sich an allen Seitenwänden **22** des Nebenraums **13** die Elektroden, wobei die Elektroden in einem kleinen Abstand zueinander angeordnet sind.

Alternativ befinden sich in einem hier nicht dargestellten Ausführungsbeispiel stabförmige Elektroden in Röhren, wobei diese Röhren innerhalb des Nebenraums angeordnet werden. In den Röhren wird, wie auch in der Vakuumkammer, ein Vakuum gebildet und anschließend eine Spannung an die Elektroden angelegt. Das in dem Nebenraum erzeugte Plasma breitet sich anschließend im Behandlungsraum aus. Für die Erzeugung des Plasmas ist eine Frequenz im MHz- Bereich oder im GHz- Bereich vorgesehen.

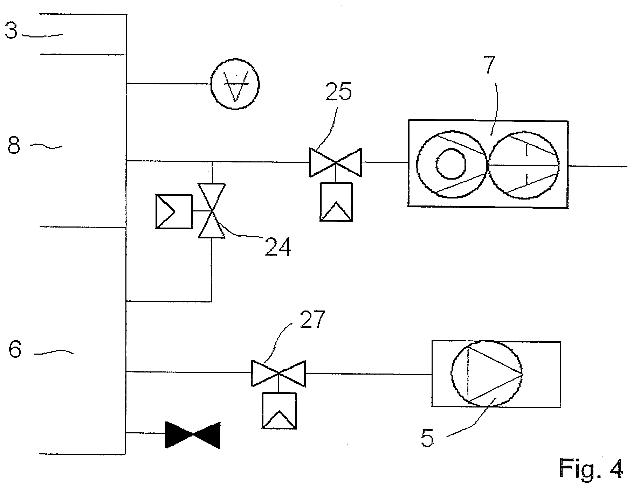

In der Figur 4 ist ein Schaltbild einer Anordnung der Vakuumpumpen dargestellt. Die Vakuumpumpen **5, 7** werden zur Erzeugung eines Plasmas beziehungsweise eines Niederdruckplasmas eingesetzt. Der Innenraum **6** wird luftdicht verschlossen und zusammen mit der Plasmaeinrichtung **3** mittels der Vakuumpumpe **5** evakuiert. Um eine Verbindung zwischen der Vakuumpumpe **5,** dem Innenraum **6** und der Vakuumkammer **8** herzustellen, befinden sich ein erstes Ventil 27 und ein zweites Ventil **24** in einem geöffneten Zustand, wohingegen ein drittes Ventil **25** verschlossen ist. Das dritte Ventil **25** stellt eine Verbindung zwischen der Plasmaeinrichtung **3** und der weiteren Vakuumpumpe **7** dar. Wenn ein Druck von 0,1 mbar erreicht wurde, wird das dritte Ventil **25** geöffnet und das zweite Ventil **24** geschlossen. Der Innenraum **6** und die Vakuumkammer **8** sind folglich nicht mehr miteinander verbunden. Die weitere Vakuumpumpe **7** wird eingeschaltet und erzeugt in der Vakuumkammer **8** einen geringeren Druck als in dem Innenraum **6.** Nach der Evakuierung wird ein Prozessgas in den Innenraum **6** eingeleitet und eine Wechselspannung an die Elektroden **23** angelegt. Die Plasmaeinrichtung **3** weist eine Arbeitsfrequenz von 13,56 MHz auf.

Es findet eine Reinigung der Kleinteile statt, indem lone in dem Plasma eine Bindung mit organischen Verschmutzungen an einer Oberfläche der Kleinteile eingehen. Zusätzlich wird die Oberfläche der Kleinteile aktiviert, da freie Radikale eine Verbindung mit der Oberfläche der Radikale eingehen. Das Prozessgas wird ständig ausgetauscht, das heißt, dass es im Nebenraum **13** eingeführt und beispielsweise an einer dem Nebenraum **13** gegenüberliegenden Seite des Gehäuses **2** abgesaugt wird. Dies führt zu einer zusätzlichen Ausbreitung des Plasmas in dem Innenraum **6** des Gehäuses **2.**

Die Dreheinrichtung **18** wird in diesem Ausführungsbeispiel gegen den Uhrzeigersinn gedreht. Folglich werden die Kleinteile in den Trägern **17** gewälzt und kommen von allen Seiten mit dem Plasma in Berührung. Durch die Drehbewegung ändert sich ein Abstand zwischen den Kleinteilen und der Plasmaeinrichtung **3** kontinuierlich. Verstärkt wird die Oberflächenbehandlung der Kleinteile dadurch, dass diese sich in der Nähe der Plasmaeinrichtung **3** im freien Fall befinden. Dementsprechend werden die Kleinteile gleichmäßig von allen Seiten oberflächenbehandelt.

Nach der Oberflächenbehandlung wird der Innenraum **6** des Gehäuses belüftet und das Prozessgas abgesaugt. Die oberflächenbehandelten Kleinteile werden nunmehr aus dem Gehäuse **2** entnommen und sind für weitere Behandlungszwecke einsetzbar.

### Bezugszeichenliste

- 1: Vorrichtung
- 2: Gehäuse
- 3: Plasmaeinrichtung
- 4: Steuereinheit
- 5: Vakuumpumpe
- 6: Innenraum
- 7: Vakuumpumpe
- 8: Vakuumkammer
- 9: Kühleinrichtung
- 10: Schaltschrank
- 11: Pneumatikschrank
- 12: Behandlungsraum
- 13: Nebenraum
- 14: Achse
- 15: Stirnfläche
- 16: Stirnfläche
- 17: Träger
- 18: Dreheinrichtung
- 19: Drehachse
- 20: Tür
- 21: Mantelfläche
- 22: Seitenwände
- 23: Elektrode
- 24: zweites Ventil
- 25: drittes Ventil
- 26: Verglasung
- 27: erstes Ventil

## Patentansprüche

1. Vorrichtung (1) zum Behandeln von Kleinteilen mittels eines Plasmas, umfassend
- ein zylinderförmiges Gehäuse (2) mit einem druckdicht abschließbaren Innenraum (6), das eine mittels einer Tür (21) verschließbare Öffnung aufweist,
- mindestens einen Träger (17), wobei der Träger (17) durch die Öffnung sowohl in das Gehäuse (2) einbringbar als auch daraus entnehmbar ist,
- eine Dreheinrichtung (18), mittels derer der mindestens eine Träger (17) in dem Gehäuse (2) um eine horizontale Drehachse (19) drehbar ist, wobei die Dreheinrichtung (18) geeignet ist, ein Umwälzen der Kleinteile zu ermöglichen, wobei der mindestens eine Träger in einem radialen Abstand zu der Drehachse (19) angeordnet ist,
- eine Vakuumpumpe (5), mittels derer der Innenraum (6) des Gehäuses (2) evakuierbar ist,
- eine Plasmaeinrichtung (3), umfassend zwei stillstehende voneinander beabstandete Elektroden (23) zur Erzeugung eines Plasmas, wobei sich das Plasma zwischen den Elektroden (23) erstreckt, wobei die Plasmaeinrichtung (3) sich in einem Nebenraum (13) befindet, der außerhalb eines Einwirkungsbereichs angeordnet ist, der von der Dreheinrichtung (18), dem Träger (17) und den zu behandelnden Kleinteilen überstrichen wird und einen Teil des Innenraums (6) bildet,
wobei die Plasmaeinrichtung (3) so angeordnet ist, dass das Plasma sich zumindest über einen Bereich des Innenraums (6) des Gehäuses (2) erstreckt und zumindest zeitweise auf die sich in oder an dem Träger (17) befindlichen oder sich mit diesem bewegenden Kleinteile einwirkt,
wobei eine Gehäusebreite einem Abstand zwischen einer ersten Stirnfläche und einer zweiten Stirnfläche des zylinderförmigen Gehäuses entspricht,
**dadurch gekennzeichnet,**
**dass** der Träger (17) in Form eines Korbes zur Aufnahme einer Vielzahl zu behandelnder Kleinteile ausgebildet ist,
**dass** die Dreheinrichtung (18) keine Elektrode ist und dass die Elektroden (23) parallel zur Drehachse (19) angeordnet sind und eine Länge aufweisen, welche der Gehäusebreite entspricht, oder dass die Elektroden (23) senkrecht zu der Drehachse (19) (23) in einem Abstand zu einander angeordnet sind, der der Gehäusebreite entspricht.

2. Vorrichtung (1) nach Anspruch 1, **dadurch gekennzeichnet, dass** die Plasmaeinrichtung (3) auf einer Mantelfläche (21) des Gehäuses (2) angeordnet ist.

3. Vorrichtung (1) nach Anspruch 1 oder 2, **dadurch gekennzeichnet, dass** die Dreheinrichtung (18) eine koaxial zu einer Achse (14) des Gehäuses (2) verlaufende Drehachse (19) besitzt.

4. Vorrichtung nach einem der Ansprüche 1 bis 3, **dadurch gekennzeichnet, dass** eine Arbeitsfrequenz der Plasmaeinrichtung zwischen 2 MHz und 20 MHz, vorzugsweise zwischen 5 MHz und 15 MHZ, weiter vorzugsweise bei 13,56 MHz beträgt.

5. Vorrichtung (1) nach einem der Ansprüche 1 bis 4, **dadurch gekennzeichnet, dass** die Elektroden (23) plattenförmig oder stabförmig sind.

6. Vorrichtung (1) nach Anspruch 5, **dadurch gekennzeichnet, dass** die plattenförmigen Elektroden (23) gemeinsam eine Zarge mit vorzugsweise zwei Trennstellen bilden.

7. Vorrichtung (1) nach einem der Ansprüche 1 bis 6, **dadurch gekennzeichnet, dass** diese derart ausgerichtet ist, dass ein Prozessgas kontinuierlich in den Nebenraum (13) eingeleitet und an einer dem Nebenraum (13) abgewandten Seite des Gehäuses (2) aus dessen Innenraum (6) herausgesaugt wird.

8. Vorrichtung (1) nach einem der Ansprüche 1 bis 7, **dadurch gekennzeichnet, dass** die Plasmaeinrichtung (3) eine Vakuumkammer (8) aufweist, die von dem Innenraum (6) des Gehäuses (2) getrennt ist und mittels einer weiteren Vakuumpumpe (7) evakuierbar ist.

9. Vorrichtung (1) nach einem der Ansprüche 1 bis 8, **dadurch gekennzeichnet, dass** der mindestens eine Träger (17) relativ zu der Dreheinrichtung stillsteht.

10. Verfahren zum Behandeln von Kleinteilen mit einer Plasmavorrichtung nach Anspruch 1 mit den folgenden Verfahrensschritten:
a) In das zylinderförmige Gehäuse (2), dessen Innenraum (6) druckdicht abschließbar und durch eine verschließbare Öffnung zugänglich ist, werden die zu behandelnden Kleinteile eingebracht.
b) Der Innenraum (6) des Gehäuses (2) wird druckdicht abgeschlossen.
c) Der Innenraum (6) des Gehäuses (2) wird mittels der Vakuumpumpe (5) evakuiert.
d) Ein Plasma wird zwischen der Elektrode der Plasmaeinrichtung erzeugt, wobei das Plasma den Innenraum (6) zumindest teilweise erfüllt.
e) Die in dem Innenraum (6) des Gehäuses (2) befindlichen Kleinteile werden mittels der in dem Innenraum (6) befindlichen Dreheinrichtung (18) gedreht.
f) Die Einwirkungsbereich des Plasmas wird von der Dreheinrichtng (18), dem mindestens einem Träger (17) und den zu behandelnden Kleinteilen überstrichen so dass die Kleinteilen behandelt werden.

11. Verfahren nach Anspruch 10, **dadurch gekennzeichnet, dass** die Kleinteile in Folge der durch die Dreheinrichtung (18) bewerkstelligten Drehung während der Behandlung ihren Abstand zu der Plasmaeinrichtung (3) ändern.

12. Verfahren nach Anspruch 10 oder 11, **dadurch gekennzeichnet, dass** die Kleinteile in Folge der von der Dreheinrichtung (18) bewerkstelligten Drehung vorzugsweise zyklisch an der Plasmaeinrichtung (3) vorbei geführt werden, wobei vorzugsweise der Abstand zwischen der Plasmaeinrichtung und den Kleinteilen, die der Plasmaeinrichtung (3) am nächsten kommen, kleiner als 200 mm, vorzugsweise kleiner als 100 mm ist.

13. Verfahren nach einem der Ansprüche 10 bis 12, **dadurch gekennzeichnet, dass** die Dreheinrichtung (18) mit einer Drehzahl zwischen 10 min⁻¹ und 30 min⁻¹, vorzugsweise zwischen 12 min⁻¹ und 20 min⁻¹, rotiert.

## Claims

1. A device (1) for treating small parts by means of a plasma, comprising
- a cylindrical housing (2) with an inner chamber (6), which can be closed in a pressure-tight manner and has an opening which can be closed by means of a door (21),
- at least one support (17), it being possible both to introduce the support (17) through the opening into the housing (2) and also remove the support therefrom,
- a rotating device (18), by means of which the at least one support (17) can be rotated in the housing (2) about a horizontal rotational axis (19), the rotating device (18) being suitable to enable a circulation of the small parts, the at least one support being arranged at a radial distance from the rotational axis (19),
- a vacuum pump (5), by means of which the inner chamber (6) of the housing (2) can be evacuated,
- a plasma device (3), comprising two stationary, mutually spaced electrodes (23) for creating a plasma, the plasma extending between the electrodes (23),
the plasma device (3) being located in a side chamber (13), which is arranged outside of a region of action which is swept over by the rotating device (18), the support (17) and the small parts to be treated and forms part of the inner chamber (6),
the plasma device (3) being arranged in such a manner that the plasma extends at least over a region of the inner chamber (6) of the housing (2) and at least temporarily acts on the small parts located in or on the support (17) or moving with the same,
a housing width corresponding to a space between a first end face and a second end face of the cylindrical housing,
**characterized in that**
the support (17) is constructed in the form of a cage for accommodating a multiplicity of small parts to be treated,
**in that** the rotating device (18) is not an electrode and
**in that** the electrodes (23) are arranged parallel to the rotational axis (19) and have a length which corresponds to the housing width, or
**in that** the electrodes (23) are arranged perpendicularly to the rotational axis (19) at a distance from one another, which corresponds to the housing width.

2. The device (1) according to Claim 1, **characterized in that** the plasma device (3) is arranged on a mantle surface (21) of the housing (2).

3. The device (1) according to Claim 1 or 2, **characterized in that** the rotating device (18) has a rotational axis (19) running coaxially to an axis (14) of the housing (2).

4. The device according to one of Claims 1 to 3, **characterized in that** a working frequency of the plasma device is between 2 MHz and 20 MHz, preferably between 5 MHz and 15 MHz, further preferably is 13.56 MHz.

5. The device (1) according to one of Claims 1 to 4, **characterized in that** the electrodes (23) are plate-shaped or rod-shaped.

6. The device (1) according to Claim 5, **characterized in that** the plate-shaped electrodes (23) together form a frame, preferably with two separating points.

7. The device (1) according to one of Claims 1 to 6, **characterized in that** the device is configured in such a manner that a process gas is continuously introduced into the side chamber (13) and is sucked out of the inner chamber (6) of the housing at a side of the housing (2) facing away from the side chamber (13).

8. The device (1) according to one of Claims 1 to 7, **characterized in that** the plasma device (3) has a vacuum chamber (8), which is separate from the inner chamber (6) of the housing (2) and can be evacuated by means of a further vacuum pump (7).

9. The device (1) according to one of Claims 1 to 8, **characterized in that** the at least one support (17) is stationary relatively to the rotating device.

10. A method for treating small parts using a plasma device according to Claim 1, with the following method steps:
a) The small parts to be treated are introduced into the cylindrical housing (2), the inner chamber (6) of which can be closed in a pressure-tight manner and is accessible through a closable opening.
b) The inner chamber (6) of the housing (2) is closed in a pressure-tight manner.
c) The inner chamber (6) of the housing (2) is evacuated by means of the vacuum pump (5).
d) A plasma is created between the electrodes (23) of the plasma device, the plasma at least partially filling the inner chamber (6).
e) The small parts located in the inner chamber (6) of the housing (2) are rotated by means of the rotating device (18) located in the inner chamber (6).
f) The region of action of the plasma is swept over by the rotating device (18), the at least one support (17) and the small parts to be treated, so that the small parts are treated.

11. The method according to Claim 10, **characterized in that** the small parts change their spacing from the plasma device (3) during the treatment as a consequence of the rotation effected by the rotating device (18).

12. The method according to Claim 10 or 11, **characterized in that** the small parts are preferably cyclically guided past the plasma device (3) as a consequence of the rotation effected by the rotating device (18), wherein the spacing between the plasma device and the small parts which are closest to the plasma device (3) is smaller than 200 mm, preferably smaller than 100 mm.

13. The method according to one of Claims 10 to 12, **characterized in that** the rotating device (18) rotates with a rotational speed of between 10 min⁻¹ and 30 min⁻¹, preferably between 12 min⁻¹ and 20 min⁻¹.

## Revendications

1. Dispositif (1) pour traiter des petites pièces au moyen d'un plasma, comprenant
- un boîtier (2) cylindrique avec un compartiment intérieur (6) pouvant être fermé étanche à la pression, qui comporte une ouverture fermable au moyen d'une porte (21),
- au moins un support (17), le support (17) pouvant être aussi bien mis en place dans le boîtier (2) que retiré de celui-ci à travers l'ouverture,
- un dispositif rotatif (18) au moyen duquel au moins un support (17) peut être tourné dans le boîtier (2) autour d'un axe de rotation horizontal (19), le dispositif rotatif (18) étant adapté pour permettre un retournement des petites pièces, au moins un support étant disposé à une distance radiale de l'axe de rotation (19),
- une pompe à vide (5) au moyen de laquelle le compartiment intérieur (6) du boîtier (2) peut être évacué,
- un système à plasma (3), comprenant deux électrodes (23) fixes distantes l'une de l'autre pour produire un plasma, le plasma s'étendant entre les électrodes (23),
le système de plasma (3) se trouvant dans un compartiment secondaire (13), qui est disposé en dehors d'une zone d'effet qui est balayée par le dispositif rotatif (18), le support (17) et les petites pièces à traiter et forme une partie du compartiment intérieur (6),
le système de plasma (3) étant disposé de telle manière que le plasma s'étend au moins sur une zone du compartiment intérieur (6) du boîtier (2) et agit au moins parfois sur les petites pièces se trouvant dans ou sur le support (17) ou se déplaçant avec celui-ci,
une largeur de boîtier correspondant à un intervalle entre une première surface avant et une deuxième surface avant du boîtier cylindrique,
**caractérisé en ce que**
le support (17) est constitué sous la forme d'une corbeille pour recevoir une pluralité de petites pièces à traiter,
**en ce que** le dispositif rotatif (18) n'est pas une électrode et
**en ce que** les électrodes (23) sont disposées parallèles à l'axe de rotation (19) et comportent une longueur, laquelle correspond à la largeur de boîtier, ou
**en ce que** les électrodes (23) sont disposées perpendiculaires à l'axe de rotation (19) à distance l'une de l'autre, qui correspond à la largeur du boîtier.

2. Dispositif (1) selon la revendication 1, **caractérisé en ce que** le système à plasma (3) est disposé sur une surface d'enveloppe (21) du boîtier (2).

3. Dispositif (1) selon la revendication 1 ou 2, **caractérisé en ce que** le dispositif rotatif (18) possède un axe de rotation (19) passant coaxialement à un axe (14) du boîtier (2).

4. Dispositif selon la revendication 1 à 3, **caractérisé en ce qu'**une fréquence de travail du système de plasma se situe entre 2 MHz et 20 MHz, de préférence entre 5 MHz et 15 MHz, de préférence encore à 13,56 MHz.

5. Dispositif (1) selon l'une quelconque des revendications 1 à 4, **caractérisé en ce que** les électrodes (23) sont en forme de plaques ou de barrettes.

6. Dispositif (1) selon la revendication 5, **caractérisé en ce que** les électrodes en forme de plaques (23) forment en commun un châssis avec de préférence deux points de séparation.

7. Dispositif (1) selon l'une quelconque des revendications 1 à 6, **caractérisé en ce que** celui-ci est orienté de telle sorte qu'un gaz de traitement est introduit en continu dans le compartiment secondaire (13) et est aspiré sur un côté du boîtier (2), opposé au compartiment secondaire (13), à partir du compartiment intérieur (6) de celui-ci.

8. Dispositif (1) selon l'une quelconque des revendications 1 à 7, **caractérisé en ce que** le système de plasma (3) comporte une chambre à vide (8), qui est séparée du compartiment intérieur (6) du boîtier (2) et est évacuée au moyen d'une autre pompe à vide (7).

9. Dispositif (1) selon l'une quelconque des revendications 1 à 8, **caractérisé en ce qu'**au moins un support (17) est fixe par rapport à la direction de rotation.

10. Procédé pour traiter des petites pièces avec un dispositif à plasma selon la revendication 1, avec les étapes de procédé suivantes :
a) les petites pièces à traiter sont mises en place dans le boîtier cylindrique (2) dont le compartiment intérieur (6) peut être fermé étanche à la pression et est accessible par une ouverture obturable,
b) le compartiment intérieur (6) du boîtier (2) est fermé étanche à la pression,
c) le compartiment intérieur (6) du boîtier (2) est évacué au moyen de la pompe à vide (5),
d) un plasma est produit entre les électrodes (23) du système de plasma, le plasma remplissant au moins en partie le compartiment intérieur (6),
e) les petites pièces se trouvant dans le compartiment intérieur (6) du boîtier (2) sont tournées au moyen du dispositif de rotation (18) se trouvant dans le compartiment intérieur (6),
f) la zone d'effet du plasma est balayée par le dispositif de rotation (18), au moins un support (17) et les petites pièces à traiter de telle sorte que les petites pièces sont traitées.

11. Procédé selon la revendication 10, **caractérisé en ce que** les petites pièces modifient leur distance par rapport au système de plasma (3) pendant le traitement à la suite de la rotation réalisée par le dispositif de rotation (18).

12. Procédé selon la revendication 10 ou 11, **caractérisé en ce que** les petites pièces sont guidées de préférence de façon cyclique pour passer sur le système de plasma (3) à la suite de la rotation réalisée par le dispositif de rotation (18), la distance entre le système de plasma et les petites pièces qui approchent le plus du système de plasma (3), est inférieure à 200 mm, de préférence inférieure à 100 mm.

13. Procédé selon l'une quelconque des revendications 10 à 12, **caractérisé en ce que** le dispositif de rotation (18) tourne à une vitesse de rotation entre 10 min⁻¹ et 30 min⁻¹, de préférence entre 12 min⁻¹ et 20 min⁻¹.
